# EUROPEAN PATENT APPLICATION

(11) **EP 3 945 574 A1**
(43) Date of publication of application: **02.02.2022**
(21) Application number: 21185754.5
(22) Date of filing: 15.07.2021
(51) Int. Cl.: H01L 25/075, H01L 33/62

(54) **LIGHT EMITTING DEVICE, LIGHT EMITTING ELEMENT FILM, LIGHT EMITTING DISPLAY, AND METHOD OF MANUFACTURING LIGHT EMITTING DEVICE**

(30) Priority: 27.07.2020 JP 2020126076
(71) Applicant: Oki Electric Industry Co., Ltd., Minato-ku Tokyo 105-8460 (JP)
(72) Inventor: FURUTA, Hironori, Tokyo, 105-8460 (JP); SUZUKI, Takahito, Tokyo, 105-8460 (JP); TANIGAWA, Kenichi, Tokyo, 105-8460 (JP); NAKAI, Yusuke, Tokyo, 105-8460 (JP); JUMONJI, Shinya, Tokyo, 105-8460 (JP); MATSUO, Genichiro, Tokyo, 105-8460 (JP); ISHIKAWA, Takuma, Tokyo, 105-8460 (JP); KAWADA, Hiroto, Tokyo, 105-8460 (JP)
(74) Representative: Betten & Resch

(57) **Abstract**

Provided are a light emitting device, a light emitting element film and a light emitting display to which failure is unlikely to occur, and a method of manufacturing a light emitting device that is unlikely to cause failure to the light emitting device. A light emitting device (100) includes a substrate (110) including electrodes (111, 112), a film member (130), light emitting elements (140) arranged on the film member, and conductive members (151, 152) that electrically connect the light emitting elements and the electrodes to each other. The film member has through holes (131, 132) formed at positions corresponding to the electrodes. The conductive member includes a first conductive part (151a, 152a) extending from the light emitting element (140) to the through hole (131, 132) and a second conductive part (151b, 152b) connecting the first conductive part and the electrode to each other via the through hole.

## Description

### BACKGROUND OF THE INVENTION

### 1. Field of the Invention

The disclosure relates to a light emitting device, a light emitting element film, a light emitting display, and a method of manufacturing a light emitting device.

### 2. Description of the Related Art

Conventionally, there has been proposed a light emitting display including a plurality of LEDs (Light Emitting Diodes) arranged two-dimensionally (see Patent Reference 1, for example). This light emitting display is referred to also as a micro-LED display. However, the manufacturing process for integrating some millions of LEDs on a panel, for example, takes a long time. In such a circumstance, there has been known a method in which a plurality of LEDs formed on a base material substrate are bonded in a lump onto an LED array substrate having through vias and back side electrodes (bumps) and the LED array substrate is mounted on a mounting substrate by flip-chip bonding. Patent Reference 1 is Japanese Patent Application Publication No. 2013-171942.

However, the flip-chip bonding requires a process of heating and pressurizing the bumps of the LED array substrate in a state of having been placed on electrode pads of the mounting substrate, and there is a problem in that this process can cause failure to the LEDs.

### SUMMARY OF THE INVENTION

An object of the disclosure, which has been made to resolve the above-described problem, is to provide a light emitting device, a light emitting element film and a light emitting display to which failure is unlikely to occur, and a method of manufacturing a light emitting device that is unlikely to cause failure to the light emitting device.

A light emitting device according to an aspect of the disclosure includes a substrate including electrodes, a film member, light emitting elements arranged on the film member, and conductive members that electrically connect the light emitting elements and the electrodes to each other. The film member has through holes formed at positions corresponding to the electrodes. The conductive member includes a first conductive part extending from the light emitting element to the through hole and a second conductive part connecting the first conductive part and the electrode to each other via the through hole.

According to the disclosure, an advantage is obtained in that failure is unlikely to occur to the light emitting device.

### BRIEF DESCRIPTION OF THE DRAWINGS

In the drawings,
Fig. 1 is a schematic plan view showing the configuration of a light emitting device according to a first embodiment;
Figs. 2A and 2B are schematic plan view and a circuit diagram showing the configuration of a unit pixel of the light emitting device according to the first embodiment;
Fig. 3 is a schematic cross-sectional view taken along the line III-III in the light emitting device shown in Fig. 1;
Fig. 4 is a circuit diagram showing a light emitting display according to the first embodiment;
Figs. 5A and 5B are schematic cross-sectional views showing a manufacturing process of the light emitting device according to the first embodiment;
Figs. 6A and 6B are schematic cross-sectional views showing the manufacturing process of the light emitting device according to the first embodiment;
Fig. 7 is a flowchart showing a method of manufacturing the light emitting device according to the first embodiment;
Fig. 8 is a schematic plan view showing the configuration of a light emitting device according to a second embodiment;
Fig. 9 is a schematic cross-sectional view taken along the line IX-IX in the light emitting device shown in Fig. 8;
Figs. 10A and 10B are schematic cross-sectional views showing a manufacturing process of the light emitting device according to the second embodiment;
Figs. 11A and 11B are schematic cross-sectional views showing the manufacturing process of the light emitting device according to the second embodiment;
Fig. 12 is a flowchart showing a method of manufacturing the light emitting device according to the second embodiment;
Fig. 13 is a circuit diagram showing a current path that can be formed by a defective LED included in a light emitting display according to the second embodiment;
Fig. 14 is a schematic plan view showing the configuration of a light emitting device according to a third embodiment;
Fig. 15 is a schematic cross-sectional view taken along the line XV-XV in the light emitting device shown in Fig. 14;
Figs. 16A and 16B are schematic cross-sectional views showing a manufacturing process of the light emitting device according to the third embodiment;
Fig. 17 is a flowchart showing a method of manufacturing the light emitting device according to the third embodiment; and
Fig. 18 is a circuit diagram showing the configuration of a unit pixel of a light emitting device according to a fourth embodiment.

### DETAILED DESCRIPTION OF THE INVENTION

A light emitting device, a light emitting element film, a light emitting display, and a method of manufacturing a light emitting device according to embodiments will be described below with reference to drawings. The following embodiments are just examples and a variety of modifications are possible within the scope of the present invention.

### (First Embodiment)

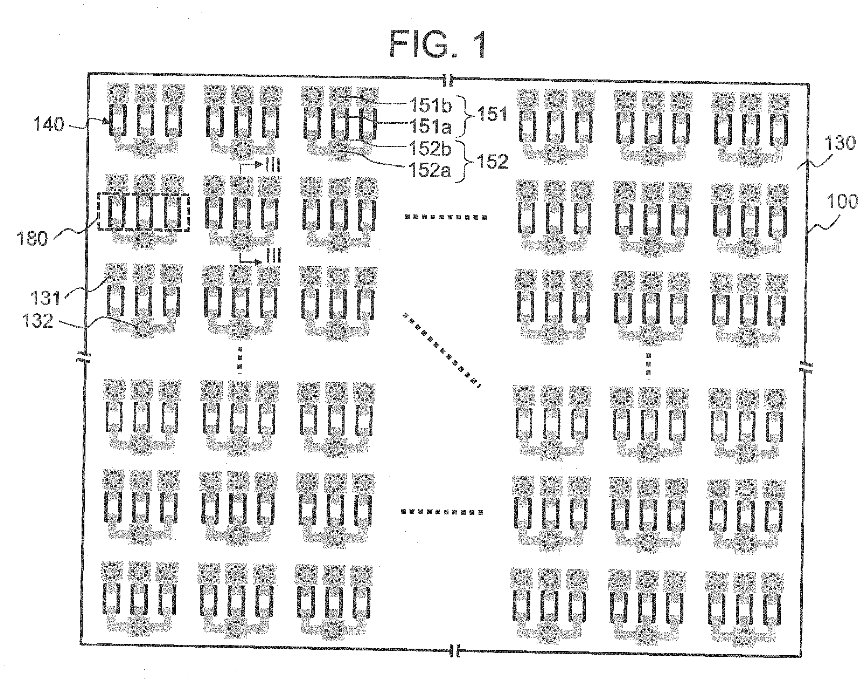

Fig. 1 is a schematic plan view showing the configuration of a light emitting device 100 according to a first embodiment. As shown in Fig. 1, the light emitting device 100 includes a plurality of pixels (unit pixels) 180 arranged in a grid (i.e., in a plurality of rows and a plurality of columns) on a film member 130 as a thin-film substrate. Each pixel 180 includes a plurality of LEDs 140 as a plurality of light emitting elements (i.e., a plurality of subpixels). In the first embodiment, an example in which each pixel 180 includes three LEDs 140 will be described. However, the number of LEDs included in each pixel 180 is not limited to three. Further, it is also possible to use light emitting elements other than LEDs as the light emitting elements.

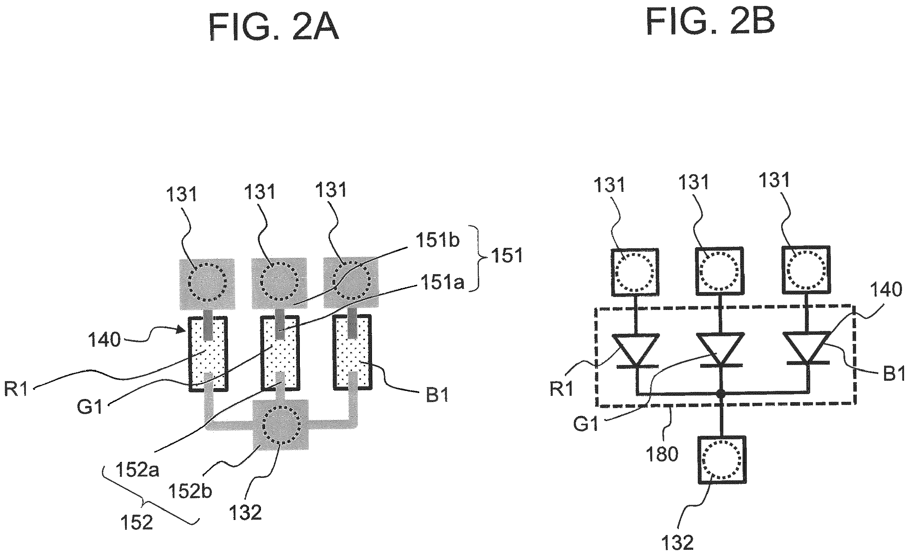

Figs. 2A and 2B are schematic plan view and a circuit diagram showing the configuration of the pixel 180 of the light emitting device 100 shown in Fig. 1. In the example shown in Figs. 2A and 2B, the three LEDs 140 are an LED (R1) for red color (R), an LED (G1) for green color (G) and an LED (B1) for blue color B.

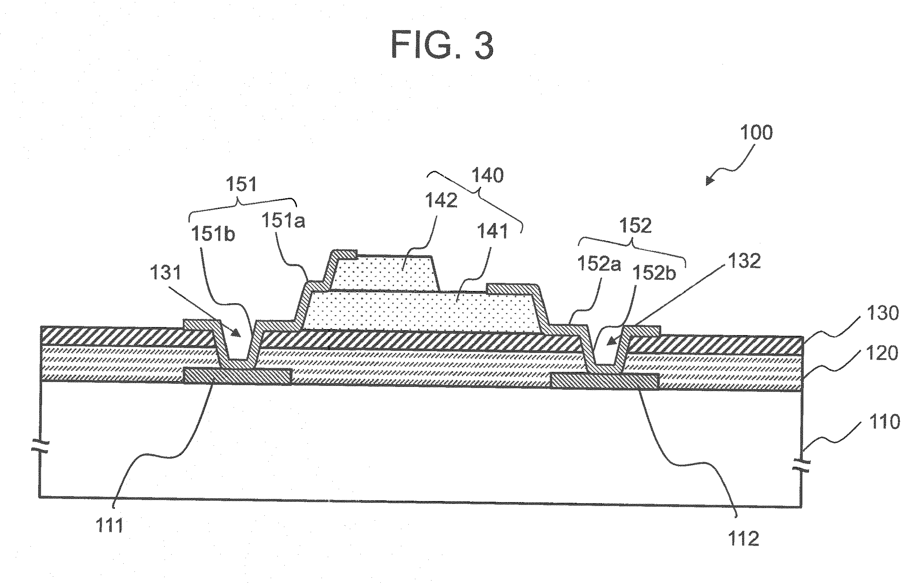

Fig. 3 is a schematic cross-sectional view taken along the line III-III in the light emitting device 100 shown in Fig. 1. The light emitting device 100 includes a mounting substrate 110 as a substrate, the film member 130, the LEDs 140, and conductive members 151 and 152. The mounting substrate 110 and the film member 130 are bonded together by using a bonding agent (e.g., bonding layer (or adhesive layer) 120).

The mounting substrate 110 includes electrode pads 111 and 112 as electrodes. Further, the mounting substrate 110 includes wiring connected to the electrode pads 111 and 112. The mounting substrate 110 may include a drive circuit for driving the LEDs 140. The mounting substrate 110 is, for example, a PCB (Printed Circuit Board), FPC (Flexible Printed Circuits) or the like.

The film member 130 has a first surface on which the LEDs 140 are arranged and a second surface as a surface on a side opposite to the first surface. In the first embodiment, the second surface is bonded to the mounting substrate 110 by the bonding layer 120. The bonding layer 120 is a layer including a bonding agent, for example. The bonding layer 120 is a layer made of material such as glass epoxy-based resin, polyimide-based resin or silicone-based resin, for example, and film thickness of the bonding layer 120 is approximately 1 µm to 30 µm.

The film member 130 has through holes 131 and 132 as openings formed at positions corresponding to the electrode pads 111 and 112. The film member 130 is formed with an organic film or an inorganic film. As the organic film, it is possible to use a film made of material such as polyimide, polyamide, polyethylene terephthalate (PET) or polyethylene naphthalate (PEN), for example. As the inorganic film, it is possible to use a film made of material such as SiO₂, Si or Al₂O₃, for example. Film thickness of the film member 130 is approximately 0.5 µm to 20 µm, for example.

The LED 140 includes a cathode layer 141 made of a semiconductor of the N-type as a first conductivity type and an anode layer 142 made of a semiconductor of the P-type as a second conductivity type. While the anode layer 142 is arranged on the cathode layer 141 in Fig. 3, the LED 140 may also have structure in which a cathode layer is arranged on an anode layer. The LED 140 is formed of AlGaAs (aluminum gallium arsenide)-based semiconductor material, AlInGaP (aluminum-indium-gallium-phosphorous)-based semiconductor material or GaN (gallium nitride)-based semiconductor material, for example.

The LED 140 is obtained by placing a semiconductor epitaxial film, as a thin-film semiconductor layer formed on a growth substrate (not shown) by epitaxial growth, on the film member 130. Film thickness of the LED 140 is approximately 1 µm to 5 µm, for example. In the first embodiment, the pixel 180 as the unit pixel is formed by three LEDs 140 (R1, G1 and B1 in Fig. 2A) arranged adjacently. By employing LEDs for R, G and B, a display device that displays full color images can be produced. Since the surface of the film member 130 has flatness within several nanometers, the LEDs 140 can be stuck on the film member 130 without using a bonding agent or the like.

The conductive member 151 includes a wiring layer 151a as a first conductive part extending from the anode layer 142 of the LED 140 to the through hole 131 (in the illustrated example, to the rim of the through hole 131) and a wiring layer 151b as a second conductive part connecting the wiring layer 151a and the electrode pad 111 to each other via the inside of the through hole 131. Put another way, in the first embodiment, the whole of the conductive member 151 is a wiring layer. The conductive member 152 includes a wiring layer 152a as a first conductive part extending from the cathode layer 141 of the LED 140 to the through hole 132 (in the illustrated example, to the rim of the through hole 132) and a wiring layer 152b as a second conductive part connecting the wiring layer 152a and the electrode pad 112 to each other via the inside of the through hole 132. Put another way, in the first embodiment, the whole of the conductive member 152 is a wiring layer. The wiring layer is, for example, a single layer of gold, copper, aluminum or the like, an alloy of two or more of these metals, or a multilayer structure of two or more of these metals and alloys.

The electrode pads 111 and 112 are formed on the mounting substrate 110, while the through holes 131 and 132 are formed through the film member 130 corresponding to the electrode pads 111 and 112. The film member 130 is bonded onto the mounting substrate 110 by using the bonding layer 120. The LEDs 140 are formed on the film member 130, and the LEDs 140 are connected to the electrode pads 111 and 112 for connection by the conductive members 151 and 152. The pixel 180 as the unit pixel is formed by the LEDs 140 (R1, G1 and B1) for R, G and B. Therefore, the anode layers of the LEDs 140 (R1, G1 and B1) are respectively connected to electrode pads 112 different from each other via through holes 132 different from each other. Further, in each unit pixel, the cathode layers of the plurality of LEDs 140 are connected to a common electrode pad 111 via a common through hole 131.

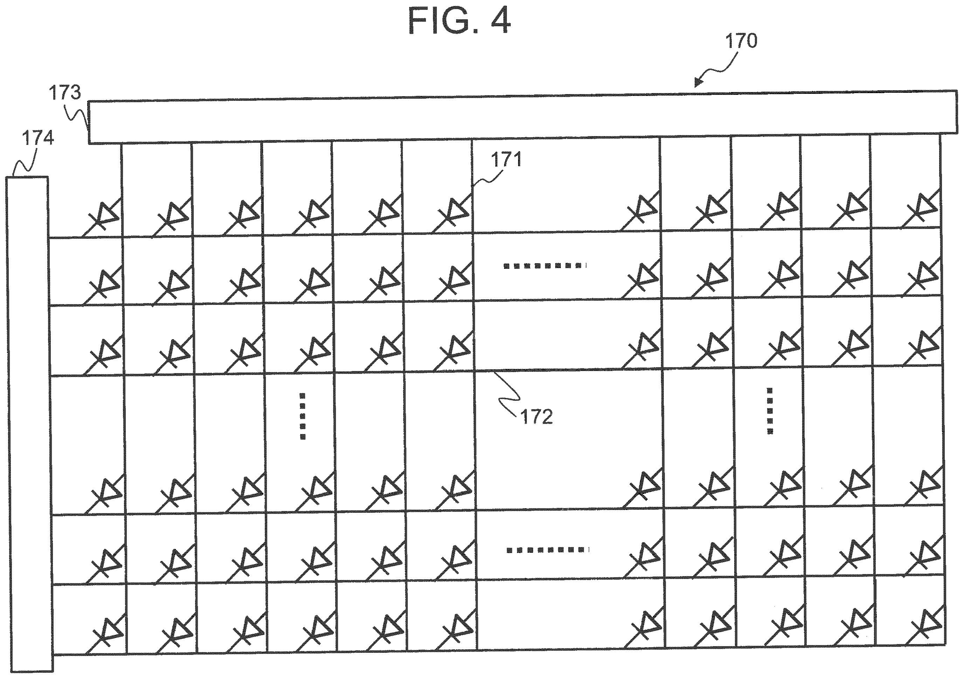

Fig. 4 is a circuit diagram showing a light emitting display 170 according to the first embodiment. The light emitting display 170 includes a plurality of light emitting devices 100. The light emitting display 170 is referred to as an LED display or a micro-LED display. The plurality of light emitting devices 100 are arranged in a plurality of rows and a plurality of columns, for example. In the mounting substrate 110, a plurality of anode lines 171 and a plurality of cathode lines 172 are formed. The plurality of anode lines 171 are connected to an anode driver 173, and the plurality of cathode lines 172 are connected to a cathode driver 174. The anode layers 142 of the plurality of LEDs 140 on the film member 130 are connected to the anode lines 171 by the conductive members 151 and the electrode pads 111 through the through holes 131. The cathode layers 141 of the plurality of LEDs 140 on the film member 130 are connected to the cathode lines 172 by the conductive members 152 and the electrode pads 112 through the through holes 132.

It is possible to make a particular LED emit light by making the cathode driver 174 on the mounting substrate 110 set a particular cathode line 172 alone in an ON state and making the anode driver 173 inject electric current exclusively into an anode line 171 connected to the LED being desired to emit light. Displaying an image is made possible by making the cathode driver 174 successively change the selected cathode line 172 and making the anode driver 173 perform the current injection in sync with the operation of the cathode driver 174.

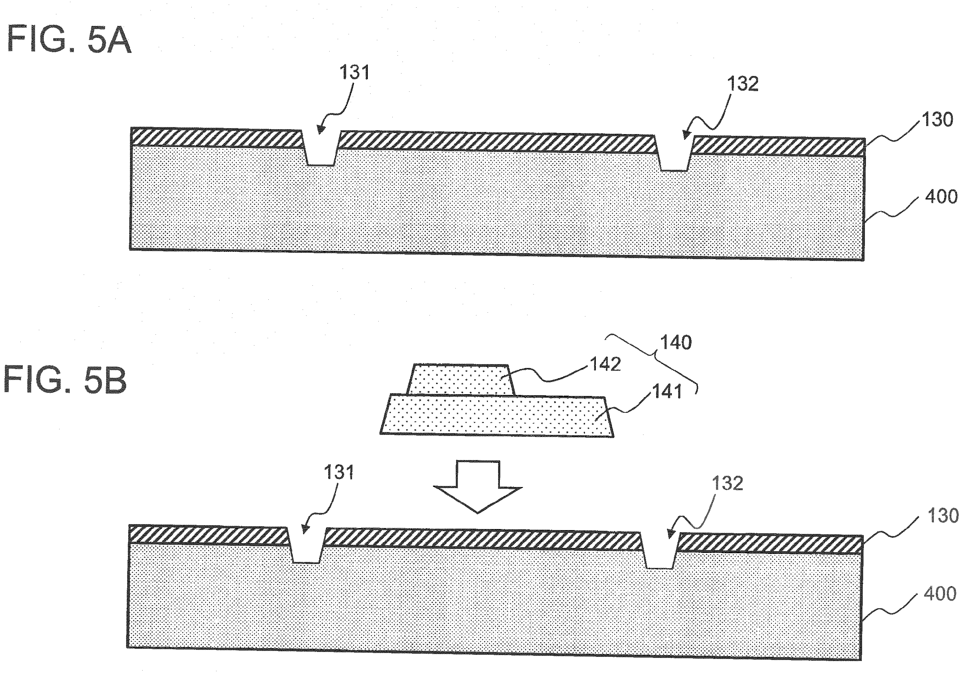

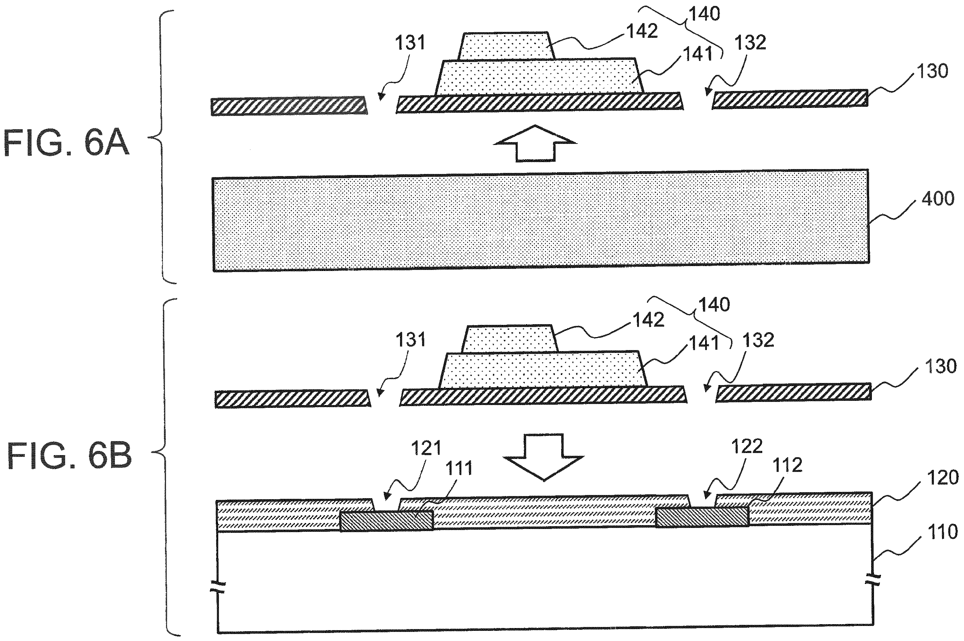

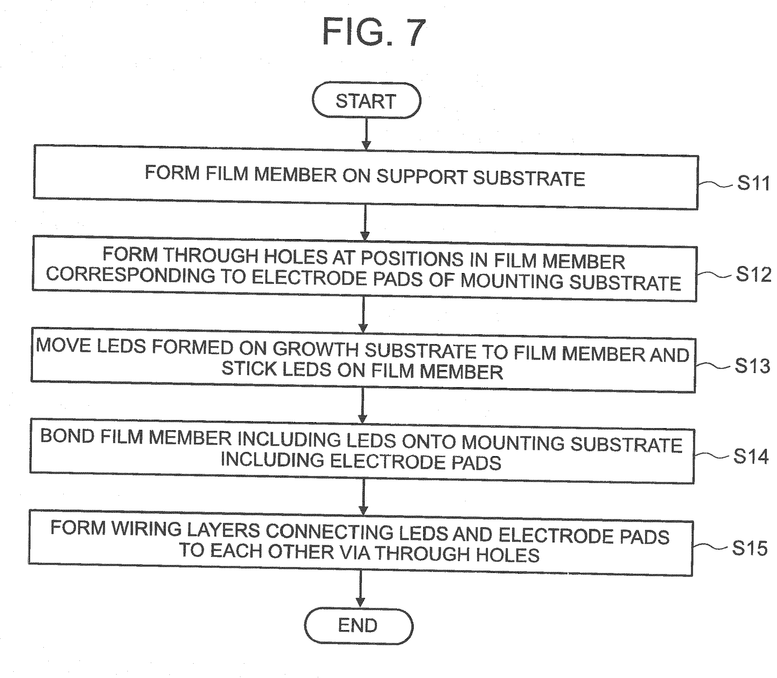

Figs. 5A and 5B and Figs. 6A and 6B are schematic cross-sectional views showing a manufacturing process of the light emitting device 100 according to the first embodiment. Fig. 7 is a flowchart showing a method of manufacturing the light emitting device 100.

The outline of the method of manufacturing the light emitting device 100 will be described below. The manufacture of the light emitting device 100 according to the first embodiment includes steps S11 to S14 of forming an intermediate structure (shown in Figs. 5A and 5B and Figs. 6A and 6B) including the mounting substrate 110 including the electrode pads 111 and 112, the film member 130 having the through holes 131 and 132 formed at the positions corresponding to the electrode pads 111 and 112, the LEDs 140 arranged on the film member 130, and the bonding layer 120 bonding the film member 130 to the mounting substrate 110, and a step S15 of forming the conductive members 151 and 152 (shown in Fig. 3) electrically connecting the LEDs 140 and the electrode pads 111 and 112 to each other. The conductive member 151, 152 includes the wiring layer 151a, 152a extending from the LED 140 to the through hole 131, 132 and the wiring layer 151b, 152b connecting the wiring layer 151a, 152a and the electrode pad 111, 112 to each other via the inside of the through hole 131, 132.

A concrete example of the method of manufacturing the light emitting device 100 will be described below. First, the film member 130 is formed on a support substrate 400 (S11), and the through holes 131 and 132 are formed at prescribed positions (the positions corresponding to the electrode pads 111 and 112) in the film member 130 (S12). Subsequently, the LEDs 140 as thin-film semiconductors formed on a growth substrate (not shown) are stuck on the film member 130 (S13). Incidentally, it is also possible to execute the step S12 after the step S13. Subsequently, this film member 130 is peeled off from the support substrate 400, moved, and bonded to the mounting substrate 110 provided with the bonding layer 120 (S14). Openings have previously been formed in parts of the bonding layer 120 corresponding to the electrode pads 111 and 112.

Subsequently, the conductive members 151 and 152 as wiring layers extending from the LEDs 140 to the electrode pads 111 and 112 through the through holes 131 and 132 are formed (S15).

As described above, in the first embodiment, the LEDs 140 and the electrode pads 111 and 112 are connected to each other by the conductive members 151 and 152 as the wiring layers extending from the LEDs 140 to the electrode pads 111 and 112 via the top of the film member 130 and inner surfaces of the through holes 131 and 132. As above, the process of heating and pressurizing the film member 130 in the state of having been bonded to the mounting substrate 110 is unnecessary and the temperature and the pressure at the time of bonding can be made low, and thus failure is unlikely to occur to the LEDs 140.

Further, the LEDs 140 have been formed on the film member 130, and by thinning down the bonding layer 120, all the conductive members 151 and 152 can be formed by only a wiring process (e.g., sputtering, vapor deposition or the like) and that enables simplification of the manufacturing process.

### (Second Embodiment)

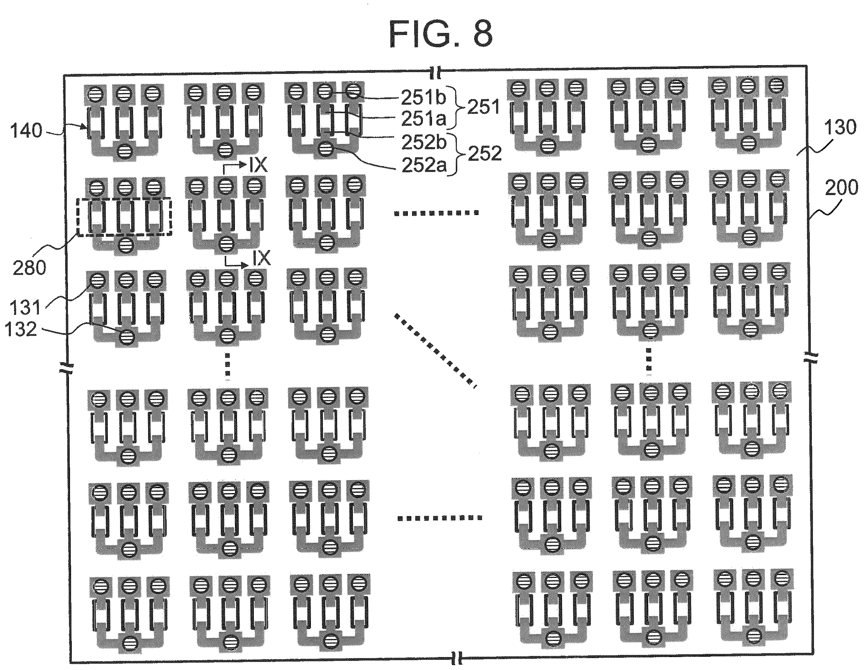

Fig. 8 is a schematic plan view showing the configuration of a light emitting device 200 according to a second embodiment. As shown in Fig. 8, the light emitting device 200 includes a plurality of pixels (unit pixels) 280 arranged in a grid (i.e., in a plurality of rows and a plurality of columns) on the film member 130 as the thin-film substrate. Each pixel 280 includes a plurality of LEDs 140 as a plurality of light emitting elements.

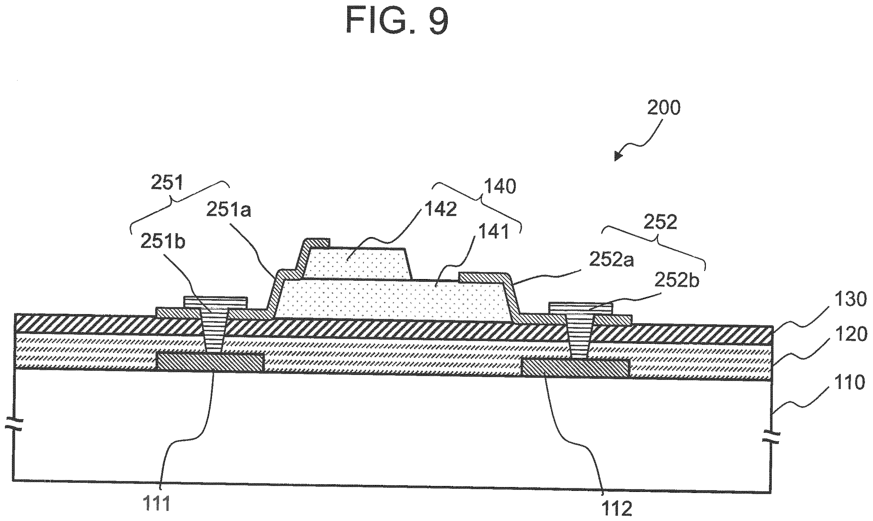

Fig. 9 is a schematic cross-sectional view taken along the line IX-IX in the light emitting device 200 shown in Fig. 8. The light emitting device 200 includes the mounting substrate 110, the film member 130, the LEDs 140, conductive members 251 and 252, and the bonding layer 120.

The light emitting device 200 according to the second embodiment differs from the light emitting device 100 according to the first embodiment in the structure of the conductive members 251 and 252. In the second embodiment, the film member 130 has a first surface on which the LEDs 140 are arranged and a second surface as a surface on the side opposite to the first surface, and the second surface is bonded to the mounting substrate 110. The conductive member 251 includes a first conductive part 251a as a wiring layer extending from the LED 140 to the through hole 131 (in the illustrated example, to the rim of the through hole 131) and a second conductive part 251b formed of a member made of conductive paste and filling in the through hole 131. The conductive member 252 includes a first conductive part 252a as a wiring layer extending from the LED 140 to the through hole 132 (in the illustrated example, to the rim of the through hole 132) and a second conductive part 252b formed of a member made of the conductive paste and filling in the through hole 132. The conductive paste is silver ink, for example, and can be injected into an intended region by the ink jet method.

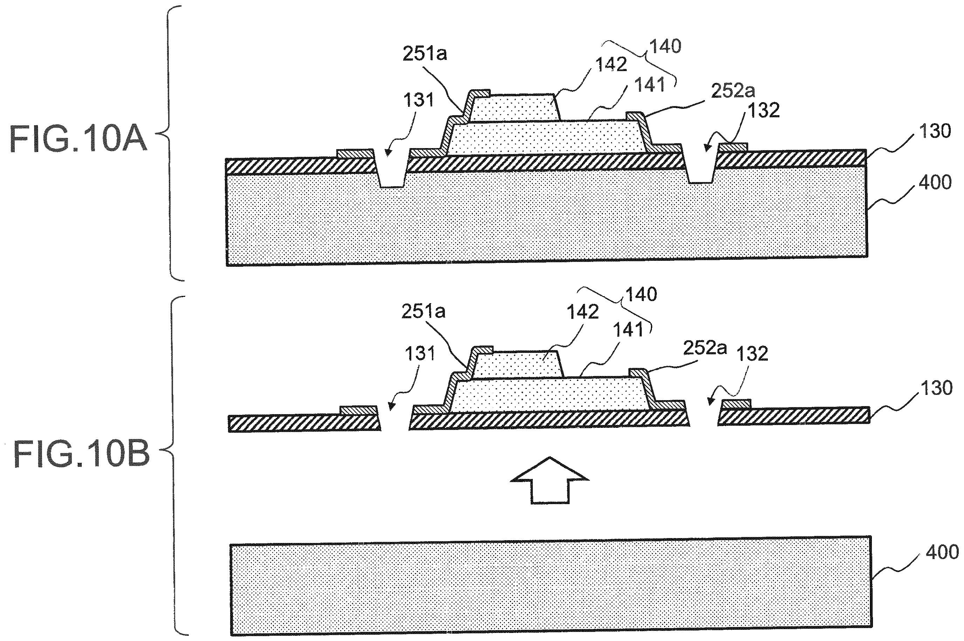

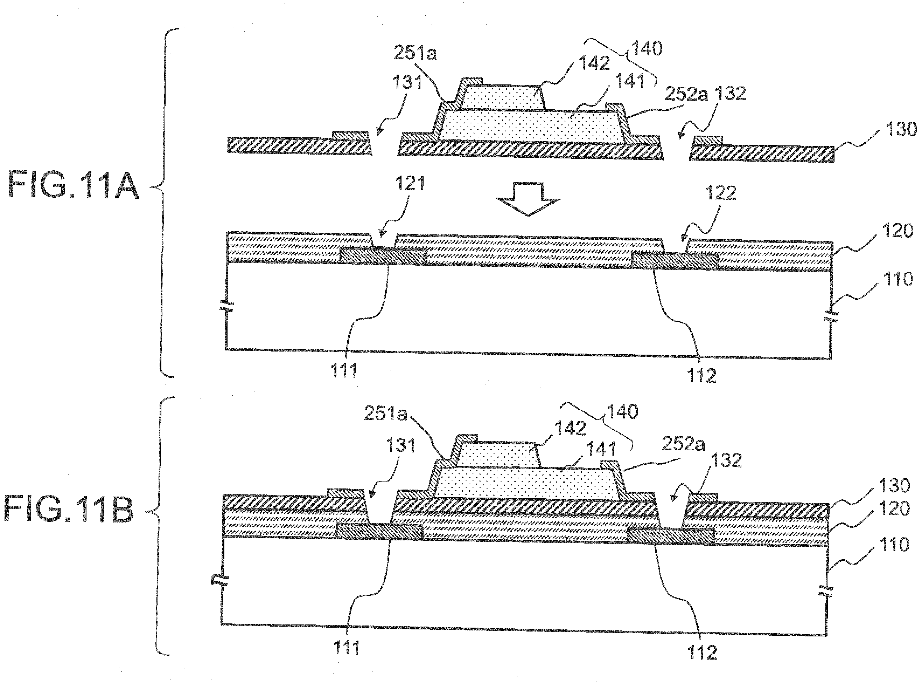

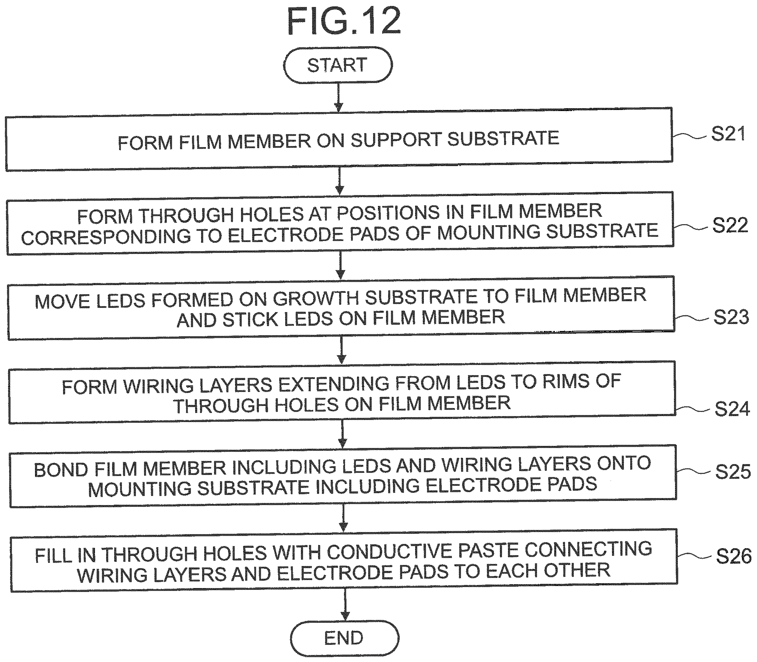

Figs. 10A and 10B and Figs. 11A and 11B are schematic cross-sectional views showing a manufacturing process of the light emitting device 200 according to the second embodiment. Fig. 12 is a flowchart showing a method of manufacturing the light emitting device 200.

First, the outline of the method of manufacturing the light emitting device 200 will be described below. The method of manufacturing the light emitting device 200 according to the second embodiment includes steps (S21 to S25) of forming an intermediate structure (shown in Figs. 10A and 10B and Figs. 11A and 11B) including the mounting substrate 110 including the electrode pads 111 and 112, the film member 130 having the through holes 131 and 132 formed at the positions corresponding to the electrode pads 111 and 112, the LEDs 140 arranged on the film member 130, the first conductive parts 251a and 252a extending from the LEDs 140 to the through holes 131 and 132, and the bonding layer 120 bonding the film member 130 to the mounting substrate 110. Further, the method of manufacturing the light emitting device 200 includes a step (S26) of forming the second conductive parts 251b and 252b electrically connecting the first conductive parts 251a and 252a and the electrode pads 111 and 112 to each other by filling the conductive paste into (i.e., injecting metallic ink into) the through holes 131 and 132.

Next, a concrete example of the method of manufacturing the light emitting device 200 will be described below with reference to Fig. 12. First, the film member 130 is formed on the support substrate 400 (S21), and the through holes 131 and 132 are formed at prescribed positions (the positions corresponding to the electrode pads 111 and 112) in the film member 130 (S22). Subsequently, the LEDs 140 as the thin-film semiconductors formed on the growth substrate (not shown) are stuck on the film member 130 (S23). Incidentally, it is also possible to execute the step S22 after the step S23. Subsequently, the first conductive parts 251a and 252a extending from the LEDs 140 to the through holes 131 and 132 are formed by sputtering, vapor deposition or the like (S24). Subsequently, as shown in Fig. 11B, the film member 130 is placed on the bonding layer 120 on the mounting substrate 110 (S25). Thereafter, the second conductive parts 251b and 252b electrically connecting the first conductive parts 251a and 252a and the electrode pads 111 and 112 to each other are formed by filling the conductive paste into the through holes 131 and 132 (e.g., until the conductive paste overflows) (S26). Openings have previously been formed in parts of the bonding layer 120 corresponding to the electrode pads 111 and 112.

As described above, in the second embodiment, the LEDs 140 and the electrode pads 111 and 112 are connected to each other by forming wiring from the LEDs 140 to the through holes 131 and 132 via the top of the film member 130 by the first conductive parts 251a and 252a as the wiring layers and forming the second conductive parts 251b and 252b made of the conductive paste inside the through holes 131 and 132 and in the openings of the bonding layer 120. As above, the process of heating and pressurizing the film member 130 in the state of having been bonded to the mounting substrate 110 is unnecessary and the temperature and the pressure at the time of bonding can be made low, and thus failure is unlikely to occur to the LEDs 140.

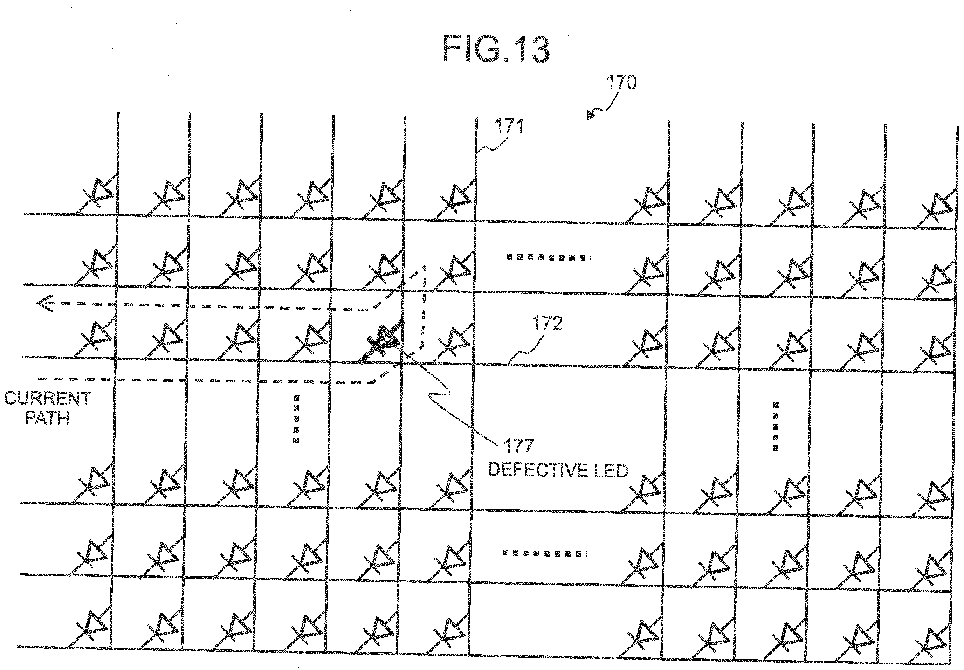

Fig. 13 is a circuit diagram showing a current path that can be formed by a defective LED included in a light emitting display according to the second embodiment. Fig. 13 shows an example in which an LED 177 is the defective LED and an undesired current path (indicated by the broken line arrow) is formed accidentally in Fig. 4. In this case, there occurs failure in which LEDs connected to the same anode line light up constantly. However, in the second embodiment, the formation of the current path due to the defective LED can be avoided by not filling in at least one of the through holes 131 and 132 with the conductive paste in the manufacturing process shown in Fig. 11B. Accordingly, it is possible to avoid the defective LED from being connected to a circuit on the mounting substrate, by which the occurrence of a bright line as a bright line constantly displayed on the screen of the light emitting display can be avoided.

Incidentally, except for the features described above, the second embodiment is the same as the first embodiment.

### (Third Embodiment)

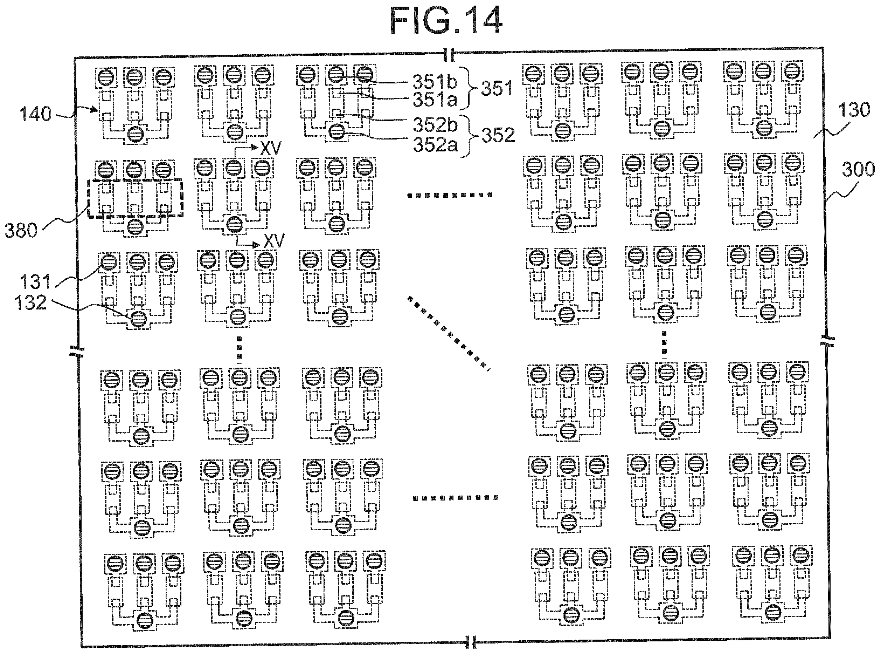

Fig. 14 is a schematic plan view showing the configuration of a light emitting device 300 according to a third embodiment. As shown in Fig. 14, the light emitting device 300 includes a plurality of pixels (unit pixels) 380 arranged in a grid (i.e., in a plurality of rows and a plurality of columns) on the film member 130 as the thin-film substrate. Each pixel 380 includes a plurality of LEDs 140 as a plurality of light emitting elements.

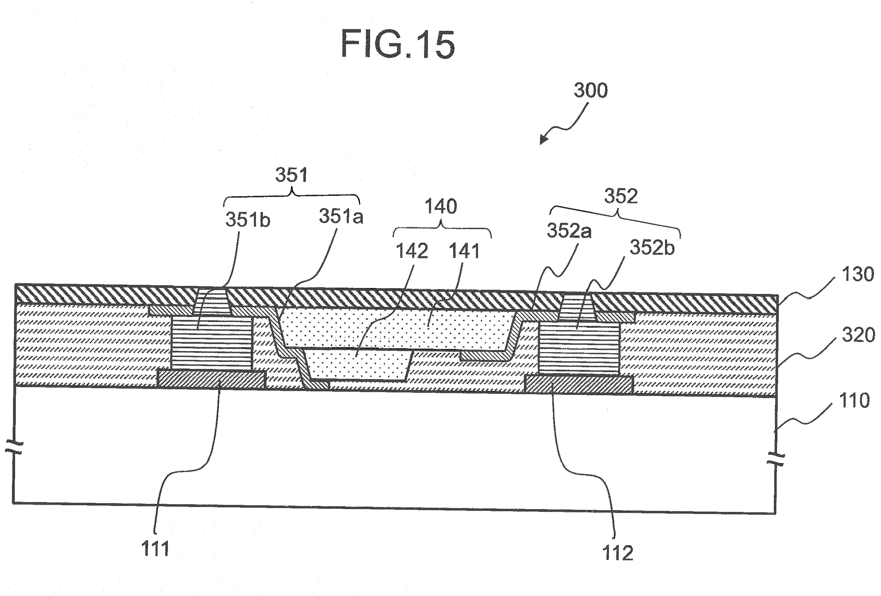

Fig. 15 is a schematic cross-sectional view taken along the line XV-XV in the light emitting device 300 shown in Fig. 14. The light emitting device 300 includes the mounting substrate 110, the film member 130, the LEDs 140, conductive members 351 and 352, and a bonding layer 320.

In the light emitting device 300 according to the third embodiment, the film member 130 has a first surface on which the LEDs 140 are arranged and a second surface as a surface on the side opposite to the first surface, and the first surface is bonded to the mounting substrate 110. In other words, while the LEDs 140 on the film member 130 were on a side opposite to the mounting substrate 110 in the above-described second embodiment, the LEDs 140 in the third embodiment are situated between the film member 130 and the mounting substrate 110.

Further, the light emitting device 300 according to the third embodiment differs from the light emitting devices 100 and 200 according to the first and second embodiments in the structure of the conductive members 351 and 352. The conductive member 351 includes a first conductive part 351a as a wiring layer extending from the LED 140 to the through hole 131 (in the illustrated example, to the rim of the through hole 131) and a second conductive part 351b formed of a member made of the conductive paste and filling in the through hole 131. The conductive member 352 includes a first conductive part 352a as a wiring layer extending from the LED 140 to the through hole 132 (in the illustrated example, to the rim of the through hole 132) and a second conductive part 352b formed of a member made of the conductive paste and filling in the through hole 132.

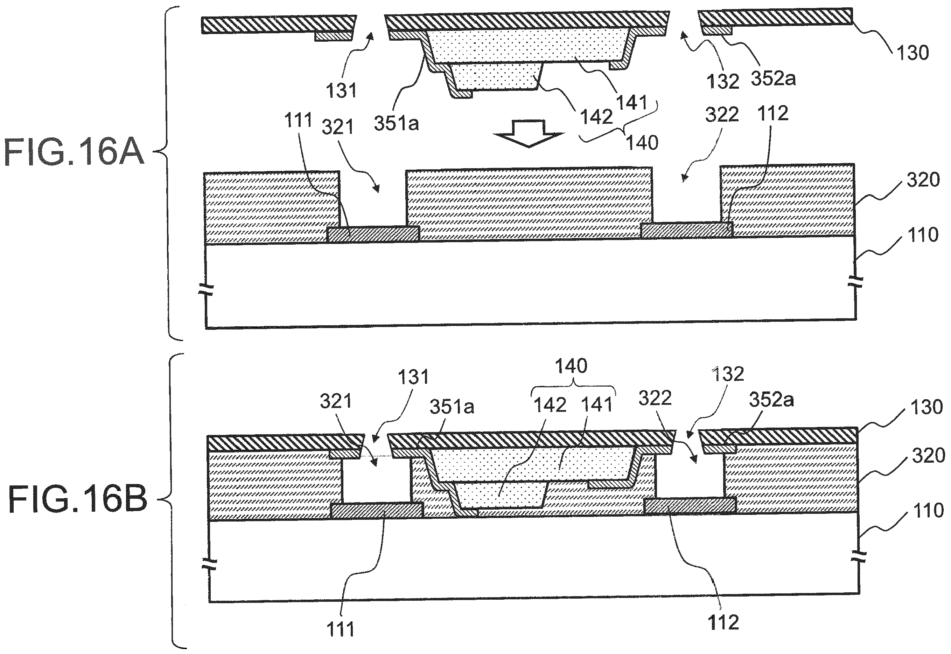

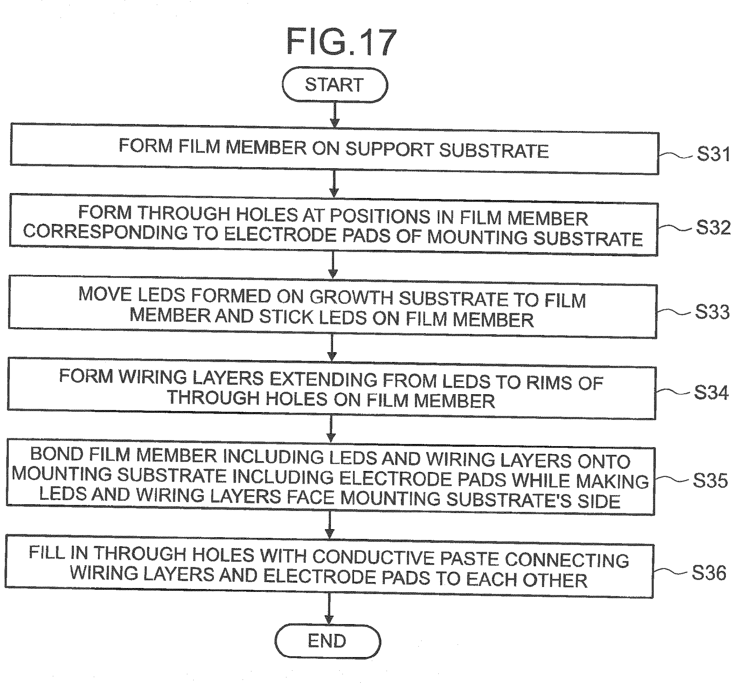

Figs. 16A and 16B are schematic cross-sectional views showing a manufacturing process of the light emitting device 300 according to the third embodiment. Fig. 17 is a flowchart showing a method of manufacturing the light emitting device 300.

First, the outline of the method of manufacturing the light emitting device 300 will be described below. The method of manufacturing the light emitting device 300 according to the third embodiment includes steps (S31 to S35) of forming an intermediate structure (shown in Figs. 16A and 16B) including the mounting substrate 110 including the electrode pads 111 and 112, the film member 130 having the through holes 131 and 132 formed at the positions corresponding to the electrode pads 111 and 112, the LEDs 140 arranged on the film member 130, the first conductive parts 351a and 352a extending from the LEDs 140 to the through holes 131 and 132, and the bonding layer 320 bonding the film member 130 to the mounting substrate 110. Further, the method of manufacturing the light emitting device 300 includes a step (S36) of forming the second conductive parts 351b and 352b electrically connecting the first conductive parts 351a and 352a and the electrode pads 111 and 112 to each other by filling the conductive paste into (i.e., injecting metallic ink into) the through holes 131 and 132 and spaces between the through holes 131 and 132 and the electrode pads 111 and 112 in the formed intermediate structure.

Next, a concrete example of the method of manufacturing the light emitting device 300 will be described below based on Fig. 17. First, the film member 130 is formed (e.g., applied) on the support substrate 400 (S31), and the through holes 131 and 132 are formed at prescribed positions (the positions corresponding to the electrode pads 111 and 112) in the film member 130 by means of etching or the like (S32). Subsequently, the LEDs 140 as the thin-film semiconductors formed on the growth substrate (not shown) are stuck on the film member 130 (S33). Incidentally, it is also possible to execute the step S32 after the step S33. Subsequently, the first conductive parts 351a and 352a extending from the LEDs 140 to the through holes 131 and 132 are formed (S34). Subsequently, as shown in Fig. 16B, the film member 130 is placed on the bonding layer 320 of the mounting substrate 110 so that the LEDs 140 are arranged between the film member 130 and the mounting substrate 110 (S35). Thereafter, the second conductive parts 351b and 352b electrically connecting the first conductive parts 351a and 352a and the electrode pads 111 and 112 to each other are formed by filling the conductive paste into the through holes 131 and 132 and openings of the bonding layer 320 (the conductive paste does not need to overflow) (S36). The openings have previously been formed in parts of the bonding layer 320 corresponding to the electrode pads 111 and 112.

As described above, in the third embodiment, the LEDs 140 and the electrode pads 111 and 112 are electrically connected to each other by forming the first conductive parts 351a and 352a as the wiring layers from the LEDs 140 to the through holes 131 and 132 via a surface of the film member 130 and forming the inside of the through holes 131 and 132 with the second conductive parts 351b and 352b made of the conductive paste. As above, the process of heating and pressurizing the film member 130 in the state of having been bonded to the mounting substrate 110 is unnecessary and the temperature and the pressure at the time of bonding can be made low, and thus failure is unlikely to occur to the LEDs 140.

As described above, in the third embodiment, the LEDs 140 are arranged between the film member 130 and the mounting substrate 110, by which undulations of the LEDs are eliminated from the surface of the device in comparison with the second embodiment, which makes it possible to inhibit damage to the LEDs caused by external factors.

Further, the possibility of current leakage can be reduced since it is unnecessary to make the conductive paste as the material of the second conductive parts 351b and 352b overflow from the holes at the top of the film member 130.

Incidentally, except for the features described above, the third embodiment is the same as the first or second embodiment.

### (Fourth Embodiment)

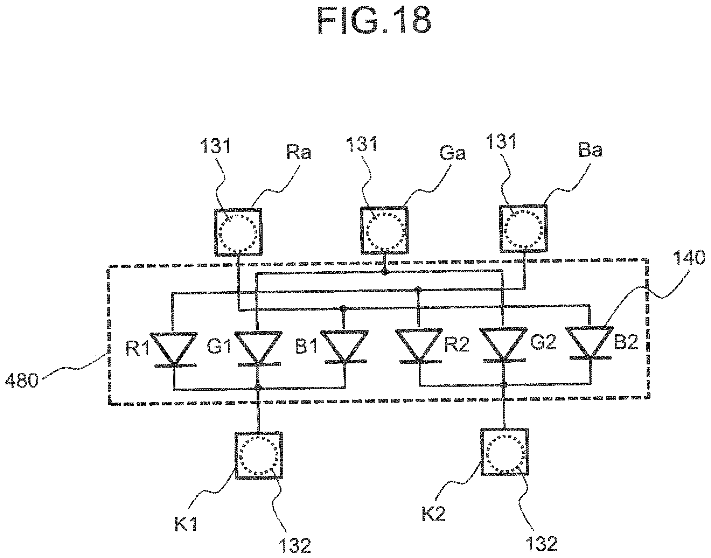

Fig. 18 is a circuit diagram showing the configuration of a unit pixel of a light emitting device according to a fourth embodiment. In the first to third embodiments described above, the unit pixel is formed by the LEDs 140 for R, G and B (i.e., the three LEDs indicated by the reference characters R1, G1 and B1 in Fig. 2B) as shown in Fig. 2B. In contrast, in the fourth embodiment, the unit pixel is formed by a total of six LEDs 140 (i.e., R1, G1, B1, R2, G2 and B2 in Fig. 18) including two LEDs for R, two LEDs for G and two LEDs for B. The anode layer of the LED 140 (R1, R2) is connected to a terminal Ra for an anode line, the anode layer of the LED 140 (Gl, G2) is connected to a terminal Ga for an anode line, and the anode layer of the LED 140 (B1, B2) is connected to a terminal Ba for an anode line. The cathode layer of the LED 140 (R1, G1, B1) is connected to a terminal K1 for a cathode line, and the cathode layer of the LED 140 (R2, G2, B2) is connected to a terminal K2 for a cathode line.

Suppose that failure of an LED 140 (B1) is detected in a manufacturing stage, the wiring of the LED 140 (B2) is formed without forming the wiring of the LED 140 (B1). Without forming the wiring of the LED 140 (B1) means, for example, without carrying out the filling in with the conductive paste of the second conductive parts 251b and 252b in Fig. 9. By this method, the unit pixel can be formed with three LEDs 140 for R, G and B (i.e., R1, G1 and B2 in Fig. 18) and pixel omission can be avoided.

Except for the features described above, the fourth embodiment is the same as any one of the first to third embodiments.

As described above, according to the fourth embodiment, the unit pixel is formed with a plurality of sets (combinations) of LEDs 140 for R, G and B (two sets in Fig. 18), and thus a normal LED can be used instead of a defective LED when the defective LED is found in the manufacturing stage. Accordingly, the pixel omission can be avoided.

### (Description of Reference Characters)

100, 200, 300: light emitting device, 110: mounting substrate (substrate), 111, 112: electrode pad, 120, 320: bonding layer, 130: film member, 131, 132: through hole, 140: LED (light emitting element), 141: cathode layer, 142: anode layer, 151, 152, 251, 252, 351, 352: conductive member, 151a, 152a, 251a, 252a, 351a, 352a: wiring layer (first conductive part), 151b, 152b: wiring layer (second conductive part), 251b, 252b, 351b, 352b: conductive paste (second conductive part), 170: light emitting display, 400: support substrate.

## Claims

1. A light emitting device (100, 200, 300) comprising:
a substrate (110) including electrodes (111, 112);
a film member (130);
light emitting elements (140) arranged on the film member (130); and
conductive members (151, 152, 251, 252, 351, 352) that electrically connect the light emitting elements (140) and the electrodes (111, 112) to each other, wherein
the film member (130) has through holes (131, 132) formed at positions corresponding to the electrodes (111, 112), and
each of the conductive members (151, 152, 251, 252, 351, 352) includes a first conductive part (151a, 152a, 251a, 252a, 351a, 352a) extending from the light emitting element (140) to the through hole (131, 132) and a second conductive part (151b, 152b, 251b, 252b, 351b, 352b) connecting the first conductive part (151a, 152a, 251a, 252a, 351a, 352a) and the electrode (140) to each other via the through hole (131, 132).

2. The light emitting device (100) according to claim 1, wherein
the film member (130) has a first surface on which the light emitting elements (140) are arranged and a second surface as a surface on a side opposite to the first surface,
the second surface is bonded to the substrate (110), and
the first conductive part (151a, 152a) and the second conductive part (151b, 152b) are wiring layers.

3. The light emitting device (200) according to claim 1, wherein
the film member (130) has a first surface on which the light emitting elements (140) are arranged and a second surface as a surface on a side opposite to the first surface,
the second surface is bonded to the substrate (110),
the first conductive part (251a, 252a) is a wiring layer, and
the second conductive part (251b, 252b) is a member made of conductive paste.

4. The light emitting device (300) according to claim 1, wherein
the film member (130) has a first surface on which the light emitting elements (140) are arranged and a second surface as a surface on a side opposite to the first surface,
the first surface is bonded to the substrate (110),
the first conductive part (351a, 352a) is a wiring layer, and
the second conductive part (351b, 352b) is a member made of conductive paste.

5. The light emitting device (100, 200, 300) according to any one of claims 1 to 4, comprising a plurality of pixels (180, 280, 380),
wherein each of the plurality of pixels (180, 280, 380) includes a plurality of the light emitting elements (140) arranged adjacently.

6. The light emitting device (100, 200, 300) according to claim 5, wherein the plurality of the light emitting elements (140) included in each of the plurality of pixels (180, 280, 380) include a light emitting element for red color, a light emitting element for green color and a light emitting element for blue color.

7. The light emitting device (100, 200, 300) according to claim 5, wherein the plurality of the light emitting elements (140) included in each of the plurality of pixels include first and second light emitting elements for red color, third and fourth light emitting elements for green color and fifth and sixth light emitting elements for blue color.

8. A light emitting element film comprising:
a film member (130);
light emitting elements (140) arranged on the film member (130); and
conductive members (151a, 152a, 251a, 252a) electrically connected to the light emitting elements (140), wherein
the film member (130) has through holes (131, 132) formed at prescribed positions, and
the conductive members (151a, 152a, 251a, 252a) are wiring layers extending from the light emitting elements (140) to the through holes (131, 132).

9. A light emitting display (170) comprising a plurality of the light emitting devices (100, 200, 300) according to any one of claims 1 to 7.

10. A method of manufacturing a light emitting device (100), the method comprising:
performing formation of through holes (131, 132) and arrangement of light emitting elements (140) on a film member (130) ;
arranging the film member (130) on a substrate (110) including electrodes (111, 112); and
forming conductive members (151, 152) between the light emitting elements (140) and the electrodes (111, 112) via the through holes (131, 132).

11. The method of manufacturing a light emitting device (100) according to claim 10, wherein the conductive member (151, 152) includes a first wiring layer extending from the light emitting element to the through hole and a second wiring layer connecting the first wiring layer and the electrode to each other via the through hole.

12. The method of manufacturing a light emitting device (100) according to claim 10 or 11, wherein the performing of the formation of the through holes (131, 132) and the arrangement of the light emitting elements (140) on the film member (130) includes sticking the light emitting elements (140) formed on a growth substrate on the film member (130) having the through holes (131, 132) or forming the through holes (131, 132) in the film member (130) on which the light emitting elements (140) formed on a growth substrate have been stuck.

13. A method of manufacturing a light emitting device (200, 300), the method comprising:
forming an intermediate structure including a substrate (110) including electrodes (111, 112), a film member (130) having through holes (131, 132) formed at positions corresponding to the electrodes (111, 112), light emitting elements (140) arranged on the film member (130), and first conductive parts (251a, 252a, 351a, 352a) extending from the light emitting elements (140) to the through holes (131, 132); and
forming second conductive parts (251b, 252b, 351b, 352b) that electrically connect the first conductive parts and the electrodes (111, 112) to each other via the through holes (131, 132).

14. The method of manufacturing a light emitting device (200, 300) according to claim 13, wherein the forming of the intermediate structure includes:
forming wiring layers as the first conductive parts (251a, 252a, 351a, 352a); and
bonding the film member (130) to the substrate (110).

15. The method of manufacturing a light emitting device (200, 300) according to claim 13 or 14, wherein the forming of the second conductive parts (251b, 252b, 351b, 352b) includes filling in the through holes (131, 132) with conductive paste as material of the second conductive parts.
